# EUROPEAN PATENT APPLICATION

(11) **EP 3 576 160 A1**
(43) Date of publication of application: **04.12.2019**
(21) Application number: 18200324.4
(22) Date of filing: 15.10.2018
(51) Int. Cl.: H01L 31/0224, H01L 31/0352, H01L 31/0747, H01L 31/18

(54) **SOLAR CELL AND PREPARATION METHOD THEREOF**

(30) Priority: 01.06.2018 CN 201810557031
(71) Applicant: Beijing Juntai Innovation Technology Co., Ltd, 100176 Beijing (CN)
(72) Inventor: YU, Cao, Beijing, Beijing 100176 (CN)
(74) Representative: Modiano, Gabriella Diana

(57) **Abstract**

A solar cell is provided. The solar cell includes a crystalline silicon substrate, and an intrinsic silicon thin film layer, a doped silicon-based thin film layer, a transparent conductive layer and electrodes, which are sequentially arranged on at least one face of the crystalline silicon substrate. The area of the doped silicon-based thin film layer is smaller than the area of the intrinsic silicon thin film layer. A preparation method of the solar cell is also provided.

## Description

The present application claims priority to Chinese Patent Application No. 201810557031.5, filed on June 1, 2018, which is hereby incorporated by reference in their entirety.

### Technical Field

The present application relates to, but is not limited to, the field of solar cells, and in particular relates to, but is not limited to, a solar cell and a preparation method thereof.

### Background

A solar cell is a device that directly converts light energy into electrical energy through photoelectric or photochemical effects.

A solar cell generally includes a crystalline silicon substrate; an intrinsic amorphous silicon-based thin film, a doped silicon-based thin film and electrodes, which are sequentially arranged on the crystalline silicon substrate. In the solar cell, the doped silicon-based thin film is integrally deposited on the intrinsic amorphous silicon-based thin film and covers the intrinsic amorphous silicon-based thin film.

### Summary

The following is an overview of the subject matter described in detail herein. This summary is not intended to limit the protection scope of the claims.

According to an embodiment of the present application, there is provided a solar cell including:
a crystal silicon substrate;
an intrinsic silicon thin film layer, a doped silicon-based thin film layer, a transparent conductive layer and electrodes, which are sequentially arranged on at least one face of the crystalline silicon substrate;
wherein the area of the doped silicon-based thin film layer is smaller than the area of the intrinsic silicon thin film layer.

Other features and advantages of the present application will be set forth in the following description and, in part, will become more apparent from the description, or may be learned by carrying out the present application. The objects and other advantages of the present application may be realized and attained by the structure particularly pointed out in the specification, claims, and drawings.

### Brief Description of Drawings

In order to more clearly explain the technical scheme in the embodiments of the present application, the drawings that need to be used in the description of the embodiments will be briefly introduced below. The accompanying drawings are used to provide a further understanding of the technical solution of the present application and form a part of the specification, and together with the embodiments of the present application, serve to explain the technical solution of the present application and do not constitute a limitation on the technical solution of the present application.
Fig. 1 is a schematic structural diagram of a solar cell according to an embodiment of the present application;
Fig. 2 is a schematic structural diagram of another solar cell according to an embodiment of the present application;
Fig. 3 is a schematic structural diagram of another solar cell according to an embodiment of the present application;
Fig. 4 is a schematic structural diagram of a solar cell on the basis of Fig. 3;
Fig. 5 is a schematic structural diagram of another solar cell on the basis of Fig. 3;
Fig. 6 is a schematic diagram of the manufacturing process of the solar cell of Fig. 3;
Fig. 7 is a schematic diagram of the manufacturing process of the solar cell of Fig. 4;
Fig. 8 is a schematic diagram of the manufacturing process of the solar cell of Fig. 5.
Reference numerals in the figures respectively indicate:
   1 - crystalline silicon substrate;
   2 - intrinsic silicon thin film layer;
   3 - doped silicon-based thin film layer;
   4 - transparent conductive layer;
   5 - electrode;
   6 - protective layer.

### Detailed Description

In order to make the technical scheme and advantages of the present application more clear, embodiments of the present application will be further described in detail below with reference to the accompanying drawings. Unless otherwise defined, all technical terms used in the embodiments of the present application have the same meaning as commonly understood by those skilled in the Art.

The inventors of the present application found that the doped silicon-based thin film has the effect of short wave (a wavelength of 300 nm to 600 nm) absorption. When incident light irradiates the solar cell, the doped silicon-based thin film absorbs a part of the short wave, and hinders the improvement of external quantum efficiency (EQE), thereby limiting the improvement of cell efficiency.

According to an embodiment of the present application, there is provided a solar cell including:
a crystal silicon substrate;
an intrinsic silicon thin film layer, a doped silicon-based thin film layer, a transparent conductive layer and electrodes, which are sequentially arranged on at least one face of the crystalline silicon substrate;
wherein an area of the doped silicon-based thin film layer is smaller than an area of the intrinsic silicon thin film layer.

In an exemplary embodiment, the transparent conductive layer may be filled on a region of the intrinsic silicon thin film layer that is not covered with the doped silicon-based thin film layer.

In an exemplary embodiment, the doped silicon-based thin film layer may include at least two doped silicon-based thin film units, and the at least two doped silicon-based thin film units are discontinuous.

In an exemplary embodiment, the transparent conductive layer may be filled on discontinuous regions of the at least two doped silicon-based thin film units.

In an exemplary embodiment, the doped silicon-based thin film unit may be strip-shaped.

In an exemplary embodiment, the doped silicon-based thin film layer may include a hollowed-out region.

In an exemplary embodiment, the hollow-out region may be filled with the transparent conductive layer.

In an exemplary embodiment, the doped silicon-based thin film layer may be an n-type doped layer or a p-type doped layer.

In an exemplary embodiment, the crystalline silicon substrate may be an n-type monocrystalline silicon wafer or a p-type monocrystalline silicon wafer.

In an exemplary embodiment, the intrinsic silicon thin film layer may include an intrinsic amorphous silicon thin film.

In an exemplary embodiment, the transparent conductive layer may include a transparent conductive oxide layer.

In an exemplary embodiment, the electrodes may include at least one electrode of a silver gate and a copper electrode.

In an exemplary embodiment, the doped silicon-based thin film layers are provided on both faces of the crystalline silicon substrate, and conductivity types of the doped silicon-based thin film layers on different faces of the crystalline silicon substrate are different.

In the present application, "conductivity types of the doped silicon-based thin film layers on different faces are different" can be understood that if the doped silicon-based thin film layer on one face is an n-type doped layer and the doped silicon-based thin film layer on the other face is a p-type doped layer; if the doped silicon-based thin film layer on one face is a p-type doped layer, the doped silicon-based thin film layer on the other face is an n-type doped layer.

According to the solar cell provided by the embodiment of the present application, the area of the doped silicon-based thin film layer is set to be smaller than the area of the intrinsic silicon thin film layer, so that a part of incident light can directly enter the crystalline silicon substrate through the transparent conductive layer and the intrinsic silicon thin film layer without passing through the doped silicon-based thin film layer, thereby reducing the absorption loss of short-wave light by the doped silicon-based thin film layer, and promoting the improvement of the cell efficiency. Moreover, it will not adversely affect other performances of the cell.

According to another embodiment of the present application, there is also provided a preparation method of a solar cell, the preparation method includes:
forming an intrinsic silicon thin film layer on at least one face of the crystalline silicon substrate;
forming a doped silicon-based thin film layer with an area smaller than that of the intrinsic silicon thin film layer on the intrinsic silicon thin film layer;
forming a transparent conductive layer on the doped silicon-based thin film layer; and forming electrodes on the transparent conductive layer.

In an exemplary embodiment, the preparation method may further include forming a transparent conductive layer on a region on the intrinsic silicon thin film layer that is not covered with the doped silicon-based thin film layer.

In an exemplary embodiment, forming a doped silicon-based thin film layer on the intrinsic silicon thin film layer with an area smaller than that of the intrinsic silicon thin film layer may include:
providing a protective lay on the doped silicon-based thin film layer, and providing a pattern on the protective layer;
removing the doped silicon-based thin film layer on the pattern; and
removing the protective layer.

In an exemplary embodiment, the forming electrodes on the transparent conductive layer may include:
forming at least one electrode of a silver gate and a copper electrode on the transparent conductive layer.

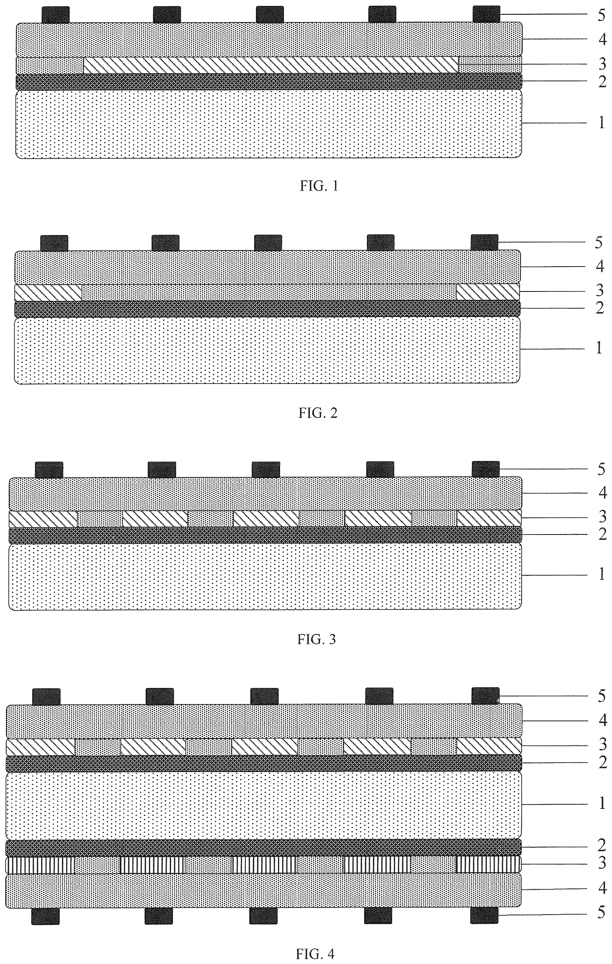

An embodiment of the present application provides a solar cell. As shown in Fig. 1, the solar cell includes a crystalline silicon substrate 1, an intrinsic silicon thin film layer 2, a doped silicon-based thin film layer 3, a transparent conductive layer 4 and electrodes 5, which are sequentially arranged on at least one face of the crystalline silicon substrate 1.

The area of the doped silicon-based thin film layer 3 is smaller than the area of the intrinsic silicon thin film layer 2.

The intrinsic silicon thin film layer 2, the doped silicon-based thin film layer 3, and the transparent conductive layer 4 are sequentially laminated on at least one face of the crystalline silicon substrate 1, and the electrodes 5 are provided on the transparent conductive layer 4.

When incident light irradiates the solar cell, a part of the incident light can directly enter the crystalline silicon substrate 1 through the transparent conductive layer 4 and the intrinsic silicon thin film layer 2 since the area of the doped silicon-based thin film layer 3 is smaller than the area of the intrinsic silicon thin film layer 2. When incident light is incident on the PN junction formed by the crystalline silicon substrate 1 and the doped silicon-based thin film layer 3, carriers are generated, the carriers are collected in the transparent conductive layer 4 through the intrinsic silicon thin film layer 2 and the doped silicon-based thin film layer 3, and then led out by the electrodes 5. The intrinsic silicon thin film layer 2 is provided to passivate the surface defects of the crystalline silicon substrate 1.

According to the solar cell provided by the embodiment of the present application, the area of the doped silicon-based thin film layer 3 is set to be smaller than the area of the intrinsic silicon thin film layer 2, so that a part of incident light can directly enter the crystalline silicon substrate 1 through the transparent conductive layer 4 and the intrinsic silicon thin film layer 2 without passing through the doped silicon-based thin film layer 3, thereby reducing the absorption loss of short-wave light in the incident light by the doped silicon-based thin film layer 3 and promoting the improvement of the cell efficiency.

In the solar cell described above, the doped silicon-based thin film layer 3 is laminated on the intrinsic silicon thin film layer 2, and the area of the doped silicon-based thin film layer 3 is smaller than the area of the intrinsic silicon thin film layer 2, so that the intrinsic silicon thin film layer 2 has a region that is not covered with the doped silicon-based thin film layer 3, that is, there may be a blank region on the intrinsic silicon thin film layer 2 on which the doped silicon-based thin film layer 3 is located, and a part of incident light may enter the crystalline silicon substrate 1 through the blank region.

The region on the intrinsic silicon thin film layer 2 that is not covered with the doped silicon-based thin film layer 3 may be a blank region or may be filled with other materials. Considering the convenience for manufacturing the solar cell, the region on the intrinsic silicon thin film layer 2 that is not covered with the doped silicon-based thin film layer 3 can be filled with the transparent conductive layer 4. The transparent conductive layer 4 can allow the incident light to pass smoothly without causing the absorption loss of short-wave light.

In the solar cell described above, various ways can be used to realize that the area of the doped silicon-based thin film layer 3 is smaller than the area of the intrinsic silicon thin film layer 2.

In an exemplary embodiment, as shown in Fig. 1, the area of the doped silicon-based thin film layer 3 can be smaller than the area of the intrinsic silicon thin film layer 2 by reducing the area around the doped silicon-based thin film layer 3 and forming a blank region around the doped silicon-based thin film layer 3.

The transparent conductive layer 4 may be filled in the blank region which is around the doped silicon-based thin film layer 3 and corresponds to the intrinsic silicon thin film layer 2.

When in use, a part of the incident light can directly enter the crystalline silicon substrate 1 via the intrinsic silicon thin film layer 2, which can pass through the transparent conductive layer 4 and through the blank region around the doped silicon-based thin film layer 3, so that the part of light does not pass through the doped silicon-based thin film layer 3, thereby reducing the absorption loss of short-wave light in the incident light by the doped silicon-based thin film layer 3 and promoting the improvement of cell efficiency.

In an exemplary embodiment, as shown in Fig. 2, the doped silicon-based thin film layer 3 may include a hollowed-out region. For example, a blank region may be set inside the doped silicon-based thin film layer 3, so that the doped silicon-based thin film layer 3 forms a continuous thin film with a hollow-out region, so that the area of the doped silicon-based thin film layer 3 is smaller than the area of the intrinsic silicon-based thin film layer 2.

The technician can set the shape of the hollowed-out region as required. For example, the hollowed-out region may be a blank rectangle or a blank circle located inside the doped silicon-based thin film layer 3 (as shown in Fig. 2).

The hollow-out region may be filled with a transparent conductive layer 4.

When in use, a part of the incident light can directly enter the crystalline silicon substrate 1 via the intrinsic silicon thin film layer 2, which can pass through the transparent conductive layer 4 and through the hollow-out region on the doped silicon-based thin film layer 3, so that the part of light does not pass through the doped silicon-based thin film layer 3, thereby reducing the absorption loss of short-wave light in the incident light by the doped silicon-based thin film layer 3 and promoting the improvement of cell efficiency.

In an exemplary embodiment, as shown in Fig. 3, the doped silicon-based thin film layer 3 may also include at least two doped silicon-based thin film units, and the at least two doped silicon-based thin film units are discontinuous. That is, the area of the doped silicon-based thin film layer 3 is smaller than the area of the intrinsic silicon thin film layer 2 by providing a gap between two adjacent doped silicon-based thin film units.

The technician can set the shape of the doped silicon-based thin film unit as required, for example, the doped silicon-based thin film unit can be square ring or circular ring with different sizes, and a plurality of square ring doped silicon-based thin film units or circular ring doped silicon-based thin film units are sleeved together to form the doped silicon-based thin film layer 3. In addition, considering the convenience of the preparation process, the doped silicon-based thin film unit can also be strip-shaped (as shown in Fig. 3), for example, straight strip-shaped or an arc strip-shaped. This arrangement not only facilitates the process preparation, but also facilitates the subsequent arrangement of the electrodes 5 to collect carriers.

In an exemplary embodiment, the transparent conductive layer 4 may be filled on the discontinuous regions of at least two doped silicon-based thin film units.

When in use, a part of the incident light can directly enter the crystalline silicon substrate 1 through the intrinsic silicon thin film layer 2, which can pass through the transparent conductive layer 4 and through the gap between two adjacent doped silicon-based thin film units, so that the part of light does not pass through the doped silicon-based thin film layer 3, thereby reducing the absorption loss of short-wave light in the incident light by the doped silicon-based thin film layer 3 and promoting the improvement of cell efficiency.

In the solar cell described above, in order to facilitate the collection and extraction of carriers, the electrodes 5 may correspond to the doped silicon-based thin film layer 3. For example, as shown in Fig. 3, the electrodes 5 are positioned above the doped silicon-based thin film layer 3. Since the electrodes 5 do not allow light to pass through, this arrangement allows as much incident light as possible not to pass through the doped silicon-based thin film layer 3.

When in use, the transparent conductive layer 4 is formed on the doped silicon-based thin film layer 3 and covers the region on the intrinsic silicon thin film layer 2 that is not covered with the doped silicon-based thin film layer 3, and the electrodes 5 are formed on the transparent conductive layer 4 so that the electrodes 5 are positioned above the doped silicon-based thin film layer 3 and correspond to the doped silicon-based thin film layer 3. In an exemplary embodiment, the electrodes 5 may correspond to the doped silicon-based thin film unit one by one.

In the solar cell described above, the doped silicon-based thin film layer 3 may be formed on one face of the crystalline silicon substrate 1 or on both faces of the crystalline silicon substrate 1. A PN junction is formed between the doped silicon-based thin film layer 3 and the crystalline silicon substrate 1, the crystalline silicon substrate 1 may be a p-type monocrystalline silicon wafer or an n-type monocrystalline silicon wafer. Accordingly, the doped silicon-based thin film layer 3 may be an n-type doped layer or a p-type doped layer.

In the solar cell described above, the area of the doped silicon-based thin film layer 3 may not exceed 50 % of the area of the intrinsic silicon thin film layer 2.

The solar cells described above are exemplified below.

In an exemplary embodiment, as shown in Figs. 1 to 3, the solar cell includes:
a crystalline silicon substrate 1;
an intrinsic silicon thin film layer 2, a doped silicon-based thin film layer 3, a transparent conductive layer 4 and electrodes 5, which are sequentially arranged on one face of the crystalline silicon substrate 1; wherein the area of the doped silicon-based thin film layer 3 is smaller than the area of the intrinsic silicon thin film layer 2.

When the crystalline silicon substrate 1 is selected as a p-type monocrystalline silicon wafer, the doped silicon-based thin film layer 3 may be an n-type doped layer; when the crystalline silicon substrate 1 is selected as an n-type monocrystalline silicon wafer, the doped silicon-based thin film layer 3 may be a p-type doped layer. When in use, one face of the doped silicon-based thin film layer 3 is used as a light-receiving surface, since the area of the doped silicon-based thin film layer 3 is smaller than the area of the intrinsic silicon thin film layer 2, a part of incident light can directly enter the crystalline silicon substrate 1 through the transparent conductive layer 4 and the intrinsic silicon thin film layer 2 without passing through the doped silicon-based thin film layer 3, thereby reducing the absorption loss of short-wave light in the incident light by the doped silicon-based thin film layer 3 and promoting the improvement of battery efficiency.

Figs. 1 to 3 show only the structural schematic diagram of the first face of the solar cell, and the structure of the second face opposite to the first face is not shown. The structure on the second face of the solar cell in Figs. 1 to 3 may be the same as that of the current solar cell, or may be the same as that of the first face.

In an exemplary embodiment, as shown in Fig. 4, the solar cell includes:
a crystalline silicon substrate 1;
an intrinsic silicon thin film layer 2, a doped silicon-based thin film layer 3, a transparent conductive layer 4 and electrodes 5, which are sequentially arranged on both faces of the crystalline silicon substrate 1; wherein he area of the doped silicon-based thin film layer 3 is smaller than the area of the intrinsic silicon thin film layer 2.

The crystalline silicon substrate 1 may be a p-type monocrystalline silicon wafer or an n-type monocrystalline silicon wafer, and the doped silicon-based thin film layers 3 formed on different faces of the crystalline silicon substrate 1 have different conductivity types, that is, an n-type doped layer is formed on one face of the crystalline silicon substrate 1 and a p-type doped layer is formed on the opposite face of the crystalline silicon substrate 1.

When in use, any one face of the doped silicon-based thin film layer 3 is used as a light-receiving surface (the opposite face is a backlight surface). Since the area of the doped silicon-based thin film layer 3 is smaller than the area of the intrinsic silicon thin film layer 2, a part of incident light can directly enter the crystalline silicon substrate 1 through the transparent conductive layer 4 and the intrinsic silicon thin film layer 2 which are located on both faces of the cell without passing through the doped silicon-based thin film layer 3, thereby reducing the absorption loss of short-wave light in the incident light by the doped silicon-based thin film layer 3 and promoting the improvement of the cell efficiency. With this arrangement, the light absorption loss of the light-receiving surface and the backlight surface of the cell can be reduced at the same time, and the cell efficiency can be improved.

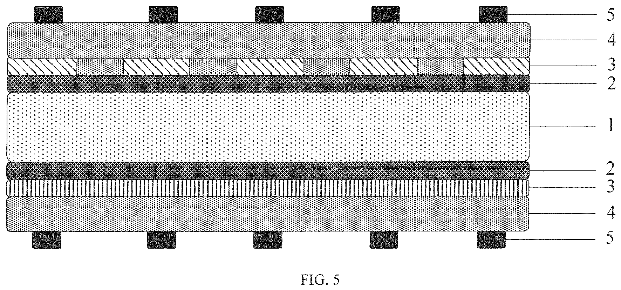

In view of the fact that the solar cell is exposed to less incident light on the backlight surface, the doped silicon-based thin film layer 3 on the backlight surface may not be treated in order to save the processes and the preparation cost, that is, as shown in Fig. 5, the area of the doped silicon-based thin film layer 3 on the backlight surface is the same as the area of the intrinsic silicon-based thin film layer 2, and only the area of the doped silicon-based thin film layer 3 on the light-receiving surface is smaller than the area of the intrinsic silicon thin film layer 2.

The doped silicon-based thin film layer 3 may be selected from any one of an amorphous silicon doped thin film layer (a-Si:H), an amorphous silicon oxygen alloy doped thin film layer (a-SiOx:H), a microcrystalline silicon oxygen alloy doped thin film layer (µc-SiOx:H), and the like, and may be a-Si:H in an exemplary embodiment.

In addition, the intrinsic silicon thin film layer 2 may include an intrinsic amorphous silicon thin film. In the exemplary embodiment, the intrinsic silicon thin film layer 2 may be selected from an amorphous silicon film (a-Si:H ) or an amorphous silicon oxygen alloy thin film (a-SiOx:H), etc.

In addition, the transparent conductive layer 4 may include a transparent conductive oxide layer, and in an exemplary embodiment, the transparent conductive layer 4 may be selected from Indium Tin Oxide (ITO) transparent conductive film, Tungsten doped Indium Oxide (IWO) transparent conductive film, or Caesium doped Indium Oxide (ICO) transparent conductive film, or the like.

The electrodes 5 may include at least one electrodes of a silver gate and a copper electrode.

The solar cell provided by the embodiment of the present application can significantly improve the optical response of the cell in the whole wave band, especially in the short wave range of 300 nm to 600 nm, so that the short wave current density of the cell is increased by 0.5mA/cm² or more, thereby improving the cell efficiency.

In the second aspect, the embodiment of the present application also provides a preparation method of the solar cell, the preparation method comprises the following steps:
Step 101: forming an intrinsic silicon thin film layer 2 on at least one face of the crystalline silicon substrate 1;
Step 102: forming a doped silicon-based thin film layer 3 with an area smaller than that of the intrinsic silicon thin film layer 2, on the intrinsic silicon thin film layer 2;
Step 103: forming a transparent conductive layer 4 on the doped silicon-based thin film layer 3; and
Step 104: forming the electrodes 5 on the transparent conductive layer 4.

The preparation method provided by the embodiment of the present application can obtain a solar cell with the area of the doped silicon-based thin film layer 3 smaller than the area of the intrinsic silicon thin film layer 2, and the solar cell enables a part of incident light to directly enter the crystalline silicon substrate 1 through the transparent conductive layer 4 and the intrinsic silicon thin film layer 2 without passing through the doped silicon-based thin film layer 3, thereby reducing the absorption loss of short-wave light in the incident light by the doped silicon-based thin film layer 3 and promoting the improvement of the cell efficiency; and the preparation method is simple and convenient for production.

For step 101, the intrinsic silicon thin film layer 2 may be formed by chemical vapor deposition (e.g., plasma enhanced chemical vapor deposition (PECVD)) on at least one face of the crystalline silicon substrate 1, wherein the crystalline silicon substrate 1 may be an n-type monocrystalline silicon wafer or a p-type monocrystalline silicon wafer. In an exemplary embodiment, an n-type single crystal silicon wafer may be selected as the crystalline silicon substrate 1, and the thickness and resistivity of the n-type single crystal silicon wafer may be the common thickness and resistivity values, for example, the thickness of the n-type single crystal silicon wafer may be 90µm to 300µm, and the resistivity may be 1 Ω cm to 12 Ω cm. The intrinsic silicon thin film layer 2 may be selected from an amorphous silicon film (a-Si:H) or an amorphous silicon oxygen alloy thin film (a-SiOx:H), and the thickness of the intrinsic silicon thin film layer 2 may be the conventional thickness value, for example, 3 nm to 15 nm.

Before depositing the intrinsic silicon thin film layer 2, the crystalline silicon substrate 1 can be treated by removing damage layer, alkali texturing, RCA cleaning, etc. to form a pyramid shape on the surface of the silicon wafer, reduce the reflection loss of light on the surface of the cell, and remove contaminants such as organic matter, particles, and metal ions on the surface of the silicon wafer.

For step 102, the doped silicon-based thin film layer 3 may firstly be deposited on the intrinsic silicon thin film layer 2.

In the preparation method described above, the doped silicon-based thin film layer 3 may be deposited on one face of the crystalline silicon substrate 1 or on both faces of the crystalline silicon substrate 1. When the doped silicon-based thin film layer 3 is deposited on one face of the crystalline silicon substrate 1, the doped silicon-based thin film layer 3 can be selected as an n-type doped silicon-based thin film or a p-type doped silicon-based thin film based on the type of the crystalline silicon substrate 1, to form a PN junction with the crystalline silicon substrate 1; when the doped silicon-based thin film layer 3 is deposited on both faces of the crystalline silicon substrate 1, an n- type doped layer may be deposited on one face of the crystalline silicon substrate 1 and a p-type doped layer may be deposited on the opposite face of the crystalline silicon substrate 1.

The doped silicon-based thin film layer 3 can be selected from any one of a-Si: H, a-SiOx: H, µc-SiOx: H, and the like, and its thickness can be the common thickness value, for example, when the doped silicon-based thin film layer 3 is an n-type doped silicon-based thin film, its thickness can be 4 nm to 20 nm, when it is a p-type doped silicon-based thin film, its thickness can be 5 nm to 30 nm.

Then, various ways can be used to realize that the area of the doped silicon-based thin film layer 3 is smaller than the area of the intrinsic silicon thin film layer 2.

In an exemplary embodiment, the doped silicon-based thin film layer 3 may be etched by laser or photolithography methods to form a blank region on the doped silicon-based thin film layer 3, so that the area of the formed doped silicon-based thin film layer 3 is smaller than the area of the intrinsic silicon thin film layer 2.

In an exemplary embodiment, it may also be realized by setting a mask.

For example, the setting a mask may include following steps:
providing a protective layer on the doped silicon-based thin film layer 3, and providing a pattern on the protective layer;
removing the doped silicon-based thin film layer 3 in the pattern; and
removing the protective layer.

The protective layer may be a SiOₓ thin film. By providing a pattern on the protective layer, the protective layer inside the provided pattern can be removed to expose the doped silicon-based thin film layer 3.

During the preparation, a protective layer can be deposited on the doped silicon-based thin film layer 3 on one or both faces of the crystalline silicon substrate 1 according to actual needs, and then the required pattern can be scribed on the protective layer by a laser scribing method; then, a chemical etching method is used to immerse one face of the crystalline silicon substrate 1 that is provided with the protective layer into a first etching solution (e.g., alkali solution and deionized water) to remove the doped silicon-based thin film layer 3 inside the pattern (i.e., not covered with the protective layer), and then to immerse the face into a second etching solution (e.g., HF solution) to remove the protective layer, so that the area of the formed doped silicon-based thin film layer 3 can be smaller than the area of the intrinsic silicon thin film layer 2.

The deposition process parameters of SiOₓ thin films can be the commonly used parameter values, for example, the deposition temperature can be 180 °C to 240 °C, the RF power can be 13.56 MHz or 40 MHz, the power density can be 0.03 W/cm² to 25 W/cm², in addition, CO₂ / SiH₄ = 0.5 to 10, H₂/SiH₄ = 1 to 1000.

The pattern scribed on the protective layer can divide the protective layer into protection units that are continuous or discontinuous with each other. Accordingly, under the mask action of the protective layer, the formed doped silicon-based thin film layer 3 may be a continuous thin film or a discontinuous thin film.

In an exemplary embodiment, the pattern may be rectangular or circular located in the middle of the protective layer, so that the doped silicon-based thin film layer 3 may form a continuous thin film having a hollowed-out region. The pattern can also be a plurality of elongated strips on the protective layer and penetrating through the protective layer, or a plurality of elongated frames or circular rings with different sizes on the protective layer, so that the doped silicon-based thin film layer 3 can be formed into a discontinuous thin film with a plurality of doped silicon-based thin film units.

For step 103, the transparent conductive layer 4 may be formed by depositing on the doped silicon-based thin film layer 3 by chemical vapor deposition method, wherein the transparent conductive layer 4 may be a transparent conductive oxide layer, such as an ITO thin film, an IWO thin film, or an ICO thin film, and the thickness of the transparent conductive layer 4 may be the conventional thickness value, for example, 70 nm to 80 nm.

Considering the convenience of actual preparation, the preparation method may further include forming a transparent conductive layer 4 on the region on the intrinsic silicon thin film layer 2 that is not covered with the doped silicon-based thin film layer 3. The transparent conductive layer 4 can allow incident light to pass smoothly without causing the absorption loss to the short wave.

During the preparation, when the transparent conductive layer 4 is deposited on the doped silicon-based thin film layer 3, the transparent conductive layer 4 is also formed on a region on the intrinsic silicon thin film layer 2 that is not covered with the doped silicon-based thin film layer 3 and is filled on the region.

For step 104, preparing the electrodes 5 on the transparent conductive layer 4 may include:
forming at least one electrode of a silver gate and a copper electrode on the transparent conductive layer 4.

During the preparation, the silver gate can be printed on the transparent conductive layer 4 by screen printing, or the copper electrode can be prepared by electroplating on the transparent conductive layer 4, or the silver gate can be printed on the transparent conductive layer 4 by screen printing and the copper electrode can be prepared by electroplating on the transparent conductive layer 4. At least one electrode of the silver gate and the copper electrode serves as the electrode 5.

In order to more clearly explain the preparation method provided in the embodiment of the present application, the following the preparation flow of the solar cell shown in Figs. 3 to 5 are exemplarily illustrated below.

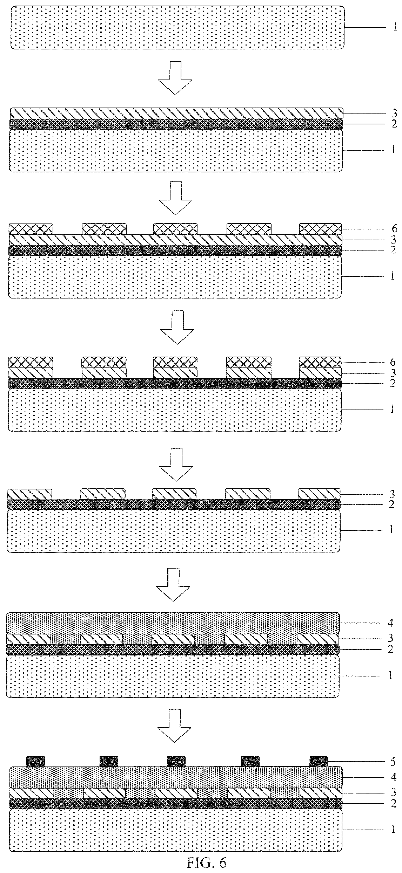

Fig. 3 is a solar cell in which a doped silicon-based thin film layer 3 is deposited on one face of a crystalline silicon substrate 1, and its preparation process is shown in Fig. 6, which may include the following steps:
depositing an intrinsic silicon thin film layer 2 on one face of the crystalline silicon substrate 1, and depositing a doped silicon-based thin film layer 3 on the intrinsic silicon thin film layer 2;
depositing a protective layer 6 on the doped silicon-based thin film layer 3, and scribing a plurality of discontinuous strip-shaped patterns on the protective layer 6, so that the protective layer 6 forms a plurality of discontinuous strip-shaped protective units while exposing the doped silicon-based thin film layer 3;
by a single-face etching method, immersing one face with the protective layer 6 in the first etching solution to remove the exposed doped silicon-based thin film layer 3 (that is not covered with the protective layer 6 );
immersing the face into a second etching solution to remove the protective layer 6;
depositing a transparent conductive layer 4 on the doped silicon-based thin film layer 3, the deposited transparent conductive layer 4 being filled on a region on the intrinsic silicon thin film layer 2 that is not covered with the doped silicon-based thin film layer 3; and
obtaining the solar cell shown in Fig. 3 by preparing the electrodes 5 on the transparent conductive layer 4 via screen printing or electroplating.

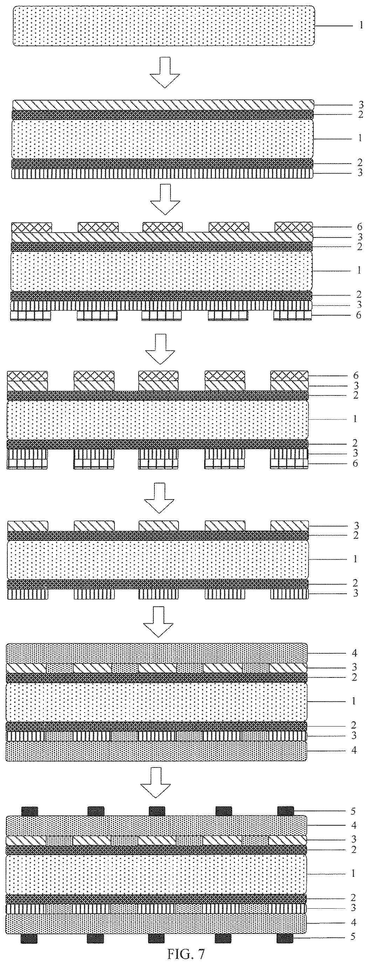

Fig. 4 is a solar cell in which the doped silicon-based thin film layer 3 is deposited on both faces of a crystalline silicon substrate 1, and its preparation process is shown in Fig. 7, which may include the following steps:
   depositing the intrinsic silicon thin film layer 2 on both faces of the crystalline silicon substrate 1, respectively, and depositing the doped silicon-based thin film layer 3 on the intrinsic silicon thin film layer 2, respectively, wherein the doped silicon-based thin film layer 3 on one face is an n-type doped layer and the doped silicon-based thin film layer 3 on the opposite face is a p-type doped layer;
   depositing a protective layer 6 on the doped silicon-based thin film layer 3, respectively, and scribing a plurality of discontinuous strip-shaped patterns on the protective layer 6 so that the protective layer 6 forms a plurality of discontinuous strip-shaped protection units while exposing the doped silicon-based thin film layer 3;
   by an etching method, immersing both faces of the crystalline silicon substrate 1 into the first etching solution, respectively, to remove the exposed doped silicon-based thin film layer 3 (that is not covered with the protective layer 6);
   immersing the two faces into the second etching solution, respectively, to remove the protective layer 6;
   depositing the transparent conductive layer 4 on the doped silicon-based thin film layer 3, respectively, and the deposited transparent conductive layers 4 is filled on the region on the intrinsic silicon thin film layer 2 that is not covered with the doped silicon-based thin film layer 3; and
   obtaining the solar cell shown in Fig. 4 by respectively preparing electrodes 5 on the transparent conductive layer 4 by screen printing or electroplating.

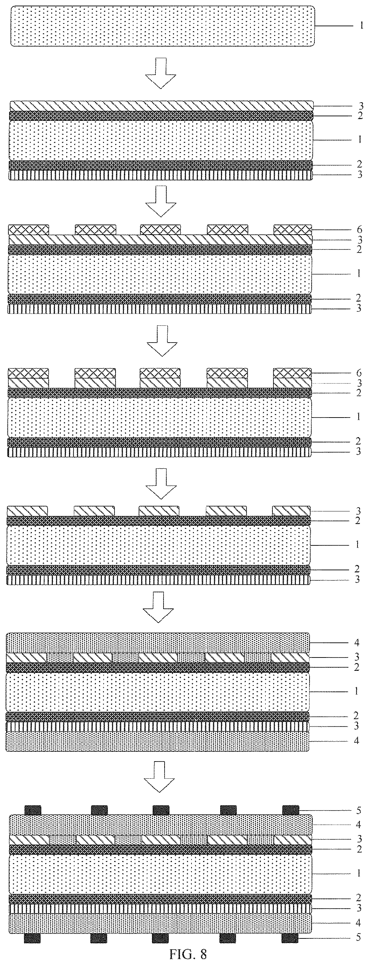

In view of the fact that the solar cell is exposed to less incident light on the backlight surface, the doped silicon-based thin film layer 3 on the backlight surface may not be treated in order to save the processes and the preparation cost, as shown in Fig. 5, and the preparation flow of the solar cell may include the following steps as shown in fig. 8:
depositing the intrinsic silicon thin film layer 2 on both faces of the crystalline silicon substrate 1, respectively, and depositing the doped silicon-based thin film layer 3 on the intrinsic silicon thin film layer 2, respectively, wherein the doped silicon-based thin film layer 3 on one face is an n-type doped layer and the doped silicon-based thin film layer 3 on the opposite face is a p-type doped layer;
depositing a protective layer 6 on the doped silicon-based thin film layer 3 on one face, and scribing a plurality of discontinuous strip-shaped patterns on the protective layer 6 so that the protective layer 6 forms a plurality of discontinuous strip-shaped protective units while exposing the doped silicon-based thin film layer 3;
by a single-face etching method, immersing one face with the protective layer 6 in the first etching solution to remove the exposed doped silicon-based thin film layer 3 (that is not covered with the protective layer 6);
immersing the face into the second etching solution to remove the protective layer 6;
depositing a transparent conductive layer 4 on the doped silicon-based thin film layer 3, the deposited transparent conductive layer 4 being filled on a region on the intrinsic silicon thin film layer 2 that is not covered with the doped silicon-based thin film layer 3; and
obtaining the solar cell shown in Fig. 5 by preparing the electrodes 5 on the transparent conductive layer 4 via screen printing or electroplating.

The solar cell prepared by the preparation method provided by the embodiment of the present application can significant improve the optical response of the cell in the whole wave band, especially in the short wave range of 300 nm to 600 nm, so that the short wave current density of the cell are increased by 0.5 mA/cm² or more, thereby improving the cell efficiency.

For SiOₓ involved in the embodiments of the present application, x may be 1 to 2.

This disclosure is illustrative of the principles of examples of the present application and is not intended to limit the application in any form or substance, or to limit the application to particular embodiments. It will be apparent to those skilled in the art that variations, changes, modifications, variations, and the like may be made to the elements, methods, and systems of the technical solutions of the examples of the present application without departing from the principles, spirit, and scope of the examples, technical solutions of the present application. Embodiments of such variations, changes, modifications, and variations are all included within equivalent examples of the present application. Although the examples of the present application may be embodied in many different forms, what is described in detail herein are merely some embodiments of the application. Furthermore, examples of the present application include any possible combination of some or all of the various embodiments described herein. All patents, patent applications, and other cited materials mentioned in this application or anywhere in any cited patent, cited patent application, or other cited material are hereby incorporated by reference in their entirety.

The above disclosure is intended to be illustrative and not exhaustive. Many variations and alternatives will be suggested to those skilled in the art. The term "including" means "including, but not limited to".

A description of exemplary embodiments of the present application has been completed herein..

## Claims

1. A solar cell comprising:
a crystalline silicon substrate (1);
an intrinsic silicon thin film layer (2), a doped silicon-based thin film layer (3), a transparent conductive layer (4) and electrodes (5), which are sequentially arranged on at least one face of the crystalline silicon substrate (1);
wherein an area of the doped silicon-based thin film layer (3) is smaller than an area of the intrinsic silicon thin film layer (2).

2. The solar cell according to claim 1, wherein a region on the intrinsic silicon thin film layer (2) that is not covered with the doped silicon-based thin film layer (3) is filled with the transparent conductive layer (4).

3. The solar cell according to claim 1, wherein the doped silicon-based thin film layer (3) comprises at least two doped silicon-based thin film units, and the at least two doped silicon-based thin film units are discontinuous.

4. The solar cell according to claim 3, wherein the transparent conductive layer (4) is filled on discontinuous regions of the at least two doped silicon-based thin film units.

5. The solar cell according to claim 3, wherein the at least two doped silicon-based thin film units are strip-shaped.

6. The solar cell according to claim 1, wherein the doped silicon-based thin film layer (3) comprises a hollowed-out region.

7. The solar cell according to claim 6, wherein the hollowed-out region is filled with the transparent conductive layer (4).

8. The solar cell according to claim 1, wherein the periphery of the doped silicon-based thin film layer (3) has a blank region.

9. The solar cell according to any one of claims 1 to 8, wherein the doped silicon-based thin film layer (3) is an n-type doped layer or a p-type doped layer.

10. The solar cell according to any one of claims 1 to 8, wherein the crystalline silicon substrate (1) is an n-type monocrystalline silicon wafer or a p-type monocrystalline silicon wafer; and/or
the intrinsic silicon thin film layer (2) comprises an intrinsic amorphous silicon thin film; and/or
the transparent conductive layer (4) comprises a transparent conductive oxide layer; and/or the electrodes (5) comprise at least one electrode of a silver gate and a copper electrode.

11. The solar cell according to any one of claims 1 to 8, wherein both faces of the crystalline silicon substrate (1) are provided with the doped silicon-based thin film layer (3), and conductivity types of the doped silicon-based thin film layers (3) on different faces of the crystalline silicon substrate (1) are different.

12. A preparation method of a solar cell, the preparation method comprising:
forming an intrinsic silicon thin film layer (2) on at least one face of a crystalline silicon substrate (1);
forming a doped silicon-based thin film layer (3) with an area smaller than that of the intrinsic silicon thin film layer (2) on the intrinsic silicon thin film layer (2);
forming a transparent conductive layer (4) on the doped silicon-based thin film layer (3); and
forming electrodes (5) on the transparent conductive layer (4).

13. The preparation method according to claim 12, further comprising: forming a transparent conductive layer (4) on a region on the intrinsic silicon thin film layer (2) that is not covered with the doped silicon-based thin film layer (3).

14. The preparation method according to claim 12, wherein the forming a doped silicon-based thin film layer (3) with an area smaller than that of the intrinsic silicon thin film layer (2) on the intrinsic silicon thin film layer (2) comprises:
providing a protective layer (6) on the doped silicon-based thin film layer (3), and providing a pattern on the protective layer (6);
removing the doped silicon-based thin film layer (3) on the pattern; and
removing the protective layer (6).

15. The preparation method according to any one of claims 12 to 14, wherein the forming electrodes (5) on the transparent conductive layer (4) comprises:
forming at least one electrode of a silver gate and a copper electrode on the transparent conductive layer (4).
